## Europäisches Patentamt
## European Patent Office
## Office européen des brevets

(11) Publication number: **0 128 433**
**B1**

(12) **EUROPEAN PATENT SPECIFICATION**

(45) Date of publication of patent specification: **12.04.89**

(51) Int. Cl.⁴: **G 03 B 41/00**

(21) Application number: **84105984.3**

(22) Date of filing: **25.05.84**

(54) Electro-magnetic alignment apparatus.

<table>
<tr><td>(30) Priority: <b>10.06.83 US 502998</b></td><td>(73) Proprietor: <b>THE PERKIN-ELMER CORPORATION<br>761 Main Avenue<br>Norwalk Connecticut 06856-0181 (US)</b></td></tr>
<tr><td>(43) Date of publication of application:<br><b>19.12.84 Bulletin 84/51</b></td><td>(72) Inventor: <b>Trost, David<br>134 Old Field Road<br>Fairfield Connecticut 06430 (US)</b><br>Inventor: <b>Galburt, Daniel<br>Silvermine Avenue<br>Norwalk Connecticut 06851 (US)</b></td></tr>
<tr><td>(45) Publication of the grant of the patent:<br><b>12.04.89 Bulletin 89/15</b></td><td></td></tr>
<tr><td>(84) Designated Contracting States:<br><b>CH DE FR GB IT LI NL</b></td><td>(74) Representative: <b>Patentanwälte Grünecker, Dr.<br>Kinkeldey, Dr. Stockmair, Dr. Schumann, Jakob,<br>Dr. Bezold, Meister, Hilgers, Dr. Meyer-Plath<br>Maximilianstrasse 58<br>D-8000 München 22 (DE)</b></td></tr>
<tr><td>(56) References cited:<br><b>DE-A-1 522 287<br>DE-A-3 132 919<br>US-A-3 789 285<br>US-A-3 935 486<br>US-A-4 019 109<br>US-A-4 087 729</b></td><td></td></tr>
</table>

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to a position adjusting apparatus, and more particularly to an electromagnetic alignment apparatus, comprising several magnets mounted in spaced relationship one with respect to the other, several coil assemblies mounted to pass through the magnetic fields of said magnets respectively, means for controlling the flow of current through said coil assemblies, respectively, means for connecting the coil assemblies to form a structure movable with respect to said magnets; means for mounting an object on said structure and having the coil assemblies arranged with respect to each other so that by controlling the supply of current to said coil assemblies said means for mounting an object can be moved selectively. This position adjusting apparatus is particularly adapted, among many other possible uses, for use in aligning the wafer in a microlithography system.

This application is closely related to the EP application No. 84 106 001.5, entitled "Electro-Magnetic Alignment Assemblies", filed on even date herewith and claiming the same priority. The disclosure therein is incorporated in the present specification by reference.

Heretofore, in order to move an object in the three degrees of freedom defined by planar motion, namely the movement in two different independent directions and the rotation about an axis perpendicular to the plane of movement, it was necessary to employ three individual linear and/or rotary motors, each driving a single axis stage with the stages stacked on top of each other. Such a system is described in US—A—4,087,729. In this system a first frame is movably mounted with respect to a fixed mounting structure by two parallel membranes. This first frame may be displaced in the direction of the X-axis with the aid of at least one coil assembly attached to this first frame and at least a magnet through the magnetic field of which the coil assembly passes. A second frame is mounted within the first frame with the aid of two further membranes such that the second frame may be moved in a second direction along the Y-axis. At least one further coil assembly is attached to the second frame and the said coil assembly passes the magnetic field of at least one magnet. Finally, means for mounting an object are rotatably mounted on the second frame and are rotated with the aid of several electrostriction elements about a Z-axis perpendicular to the plane unfolded by the other two directions of the X-axis and Y-axis.

This known system is relatively complicated and needs a costly construction. At least two stages are required, one for the X-direction stage and one for the Y-direction. The arrangement also partially complicates the movement about the Y-axis.

While such systems enjoyed reasonable success, the present invention tries to provide a new system which is less complicated and has a less costly construction.

The present invention relates to a position adjusting apparatus of the above-mentioned type and is characterized in that means are provided for rigidly connecting the coil assemblies 18, 20, 22, to form a rigid structure 25, 64, movable with respect to said magnets 12, 14, 16, 48, 50, 52, 54, and that bearing means 28 for mounting said rigid structure on a base plate 10 is provided, and that said coil assemblies 18, 20, 22, 56, 58, 60 62, being wound with respect to each other, so that by controlling the supply of current to said coils, said structure 25, 64, can be moved in a plane selectively in a first and/or a second direction (X, Y) and/or rotated about an axis (Z) being perpendicular to said plane. The inventive system merely provides one single stage and this single stage onto which the workpiece may be placed can be moved in three different directions, that is, in the X and/or Y direction and/or may be rotated about the Z-axis.

In accordance with one preferred embodiment, the means for rigidly connecting the coil assemblies includes an upper plate and a lower plate with the coil assemblies disposed there between. By the provision of an upper and a lower plate, the rigidity of this stage together with the coil assemblies may be increased.

In some cases, it may be preferable that the magnets 12, 14, 16; 48, 50, 52, 54 are mounted on said base plate 10; 46 and that the bearing means 28 support said lower plate (26; 68) on said base plate (10; 46). The base plate in particular facilitates the mounting of the magnets.

According to a further preferred embodiment, three magnets are mounted substantially in the same plane and two of said coil assemblies are wound substantially in parallel with respect to each other, while the third coil assembly is wound substantially perpendicularly to the first and second coil assemblies. In a preferred embodiment in this case the magnets may be mounted such that they form an equilateral triangle.

In another embodiment, four magnets are mounted substantially in the same plane and two of said coil assemblies are wound substantially in parallel with respect to each other, while the other two of said coil assemblies are wound substantially perpendicular to the first two of said coil assemblies. In the latter case, the magnets may be mounted such that they form a square configuration.

In order to control exactly the position of the workpiece, the apparatus may further comprise a plurality of sensor means for sensing the position of said movable structure, wherein said sensor means provide an input to said means controlling the supply of current to said coil assemblies.

Several embodiments of the invention have been chosen for purposes of illustration and description, and are shown in the accompanying drawings, forming a part of the specification. In the drawings:

Fig. 1 is a perspective view showing electromagnetic alignment apparatus constructed in accordance with the concepts of the present invention;

Fig. 2 is a vertical sectional view taken along the line indicated at 2—2 in Fig. 1;

Fig. 3 is a vector diagram illustrating the operational forces involved; and

Fig. 4 is a perspective view showing electromagnetic alignment apparatus according to another embodiment of the invention.

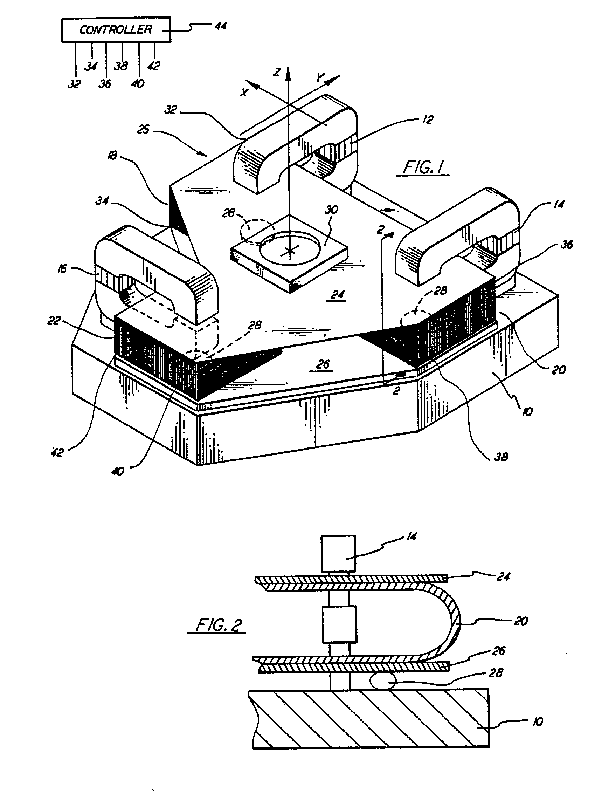

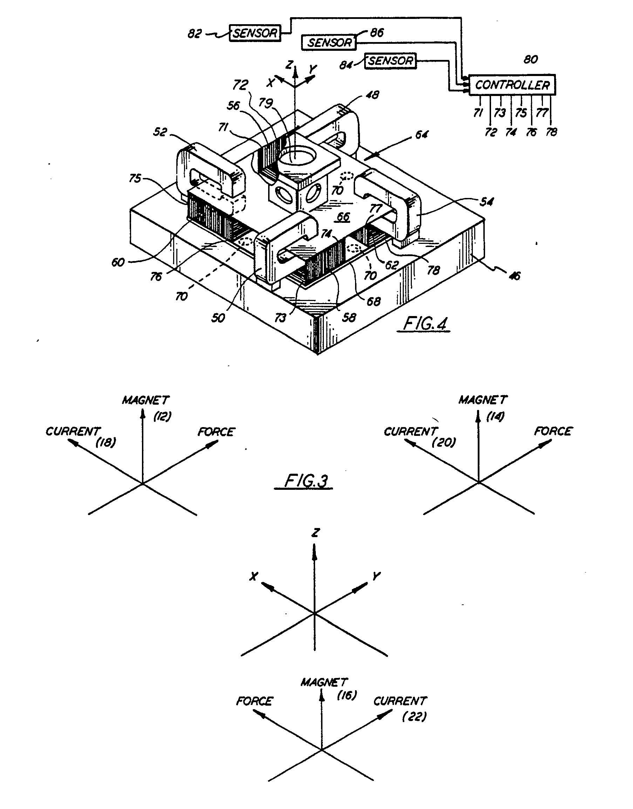

In the embodiment illustrated, on the ground structure or base plate 10 is fixedly mounted a first magnet 12, a second magnet 14 and a third magnet 16. These magnets are spaced one with respect to the other and are all mounted substantially in the same plane, and are arranged so that their magnetic fields extend in the Z direction, respectively, as indicated in Figs. 1 and 3. Three coil assemblies 18, 20 and 22 are mounted to pass through the magnetic fields of said magnets, respectively.

Referring to Figs. 1 and 2, means are provided for joining together the three coil assemblies to form a single structure, indicated generally at 25 in Fig. 1, movable with respect to the magnets. In the form of the invention illustrated, the joining means comprises an upper connecting plate 24 and a lower connecting plate 26. The lower plate is mounted on any suitable bearing means such as, for example, air pads or bearings 28 provided for the purpose.

The upper plate 24 carries a wafer mount 30, as seen in Fig. 1. The first coil 18 is provided with a first lead 32 and a second lead 34, while the second coil 20 has a first lead 36 and a second lead 38. Likewise, the third coil 22 had a first lead 40 and a second lead 42. The electrical current supplied to each of the leads is controlled by the controller 44.

In operation, under control of the controller 44, when the current in the first coil 18 and the current in the second coil 20 are both in the X direction, there results a net force on each of the two coils in the Y direction, as viewed in Fig. 3. When the current in the first and second coils are both in the opposite direction, then the resultant force is also in the opposite direction. When the two coils 18 and 20 are excited with currents of the opposite sign one with respect to the other, a torque is produced about the Z axis. In a like manner, when the third coil 22 is excited and when the current is in the opposite direction, the force is in the opposite direction. As a result, depending on the currents applied and the directions thereof, as controlled by the controller 44, movement of the unitary structure 25 and the wafer in the holder 30 can be accurately controlled in three degrees of freedom, i.e., the X and Y directions, as well as the rotary motion about the axis Z.

In the embodiment of Fig. 4, four magnets and four coil assemblies are employed for purposes of providing greater stability to the alignment apparatus. The apparatus is mounted on a base plate 46. A first magnet 48, a second magnet 50, a third magnet 52 and a fourth magnet 54 are all fixedly mounted on the base plate 46 in spaced relationship one with respect to the others. These magnets are all mounted substantially in the same plane, and are arranged so that their magnetic fields extend in the Z direction, respectively, as indicated in Fig. 4.

A first coil assembly 56, a second coil assembly 58, a third coil assembly 60 and a fourth coil assembly 62 are mounted to pass through the magnetic fields of said magnets, respectively. Means are provided for joining together the four coil assemblies to form a single structure, indicated generally at 64 in Fig. 4, movable with respect to the magnets and the base plate 46. In the embodiment of the invention illustrated in Fig. 4, the joining means includes an upper connecting plate 66 and a lower connecting plate 68. The lower plate is mounted on any suitable bearing means such as, for example, air pads or bearings 70.

The upper plate 66 carries a wafer mount 79 when the apparatus is used for aligning the wafer in a microlithography system. Each of the four coil assemblies 56, 58, 60 and 62 is provided with two leads as indicated at 71—78 in Fig. 4. The leads are connected to a controller 80 which controls the direction and flow of current to the various coils.

In operation, under control of the controller 80, when the current in the first coil 56 and the current in the second coil 58 are both in the X direction, there results a net force on each of the two coils in the Y direction, as viewed in Fig. 4. When the current in the first and second coils are both in the opposite direction, then the resultant force is also in the opposite direction. When the current in the third coil 60 and the fourth coil 62 are both in the Y direction, there results a net force on each of the coils in the X direction, as viewed in Fig. 4. When the current in the third and fourth coils are both in the opposite direction, then the resultant force is also in the opposite direction. When the two coils 56 and 58 are excited with currents of the opposite sign one with respect to the other and/or when the two coils 60 and 62 are excited with the currents of the opposite sign one with respect to the other, a torque is produced about the Z axis. The torque produced about the coils 56 and 58 with respect to the torque produced by the coils 60 and 62 could be additive or subtractive depending on the direction of current flows. As a result, depending on the currents applied and the directions thereof, as controlled by the controller 80, the movement of the unitary structure 64 and the water in the holder 79 can be accurately controlled in three degrees of freedom, i.e., the X and Y directions as well as the rotary motion about the axis Z.

Still referring to the embodiment of Fig. 4, any suitable sensor means may be used to sense the position of the object or wafer mounted on the structure 64. Thus, a sensor 82 senses the position in the X direction, sensor 84 in the Y direction, and sensor 86 in the Z direction. These sensors provide inputs to the controller 80.

It will thus be seen that the present invention does indeed provide an improved electromagnetic alignment apparatus, which effectively meets the objects mentioned hereinbefore.

**Claims**

1. Position adjusting apparatus comprising several magnets (12, 14, 16) mounted in spaced relationship one with respect to the other, several coil assemblies (18, 20, 22) mounted to pass through the magnetic fields of said magnets respectively, means (44) for controlling the flow of current through said coil assemblies, respectively, means (24, 26) for connecting the coil assemblies to form a structure movable with respect to said magnets, means (30) for mounting an object on said structure, the coil assemblies being arranged with respect to each other so that by controlling the supply of current to said coil assemblies said means (30) for mounting an object can be moved selectively, characterized in that means are provided for rigidly connecting the coil assemblies (18, 20, 22) to form a rigid structure (25; 64) movable with respect to said magnets (12, 14, 16; 48, 50, 52, 54), that bearing means (28) for mounting said rigid structure on a base plate (10) is provided, and that said coil assemblies (18, 20, 22; 56, 58, 60, 62) being wound with respect to each other, so that by controlling the supply of current to said coils, said structure (25; 64) can be moved in a plane selectively in a first and/or a second direction (X, Y) and/or rotated about an axis (Z) being perpendicular to said plane.

2. Apparatus according to claim 1, characterized in that said means for rigidly connecting the coil assemblies (18, 20, 22; 56, 58, 60, 62) includes an upper plate (24; 66) and a lower plate (26; 68) with the coil assemblies (18, 20, 22; 56, 58, 60, 62) disposed therebetween.

3. Apparatus according to claim 2, characterized in that the magnets (12, 14, 16; 48, 50, 52, 54) are mounted on said base plate (10; 46) and that the bearing means (28) support said lower plate (26; 68) on said base plate (10; 46).

4. Apparatus according to any one of claims 1—3 characterized in that three magnets (12, 14, 16) are mounted substantially in the same plane, that two of said coil assemblies (18, 20) being wound substantially in parallel with respect to each other, and the third coil assembly (22) being wound substantially perpendicularly to the first and second coil assemblies (18, 20).

5. Apparatus according to claim 4 characterized in that said magnets (12, 14, 16) are so mounted that they form an equilateral triangle.

6. Apparatus according to any one of claims 1—3 characterized in that four magnets (48, 50, 52, 54) are mounted substantially in the same plane; that two of said coil assemblies (56, 58) are wound substantially in parallel with respect to each other and the other two of said coil assemblies (60, 62) are wound substantially perpendicularly to the first two of said coil assemblies.

7. Apparatus according to claim 6, characterized in that said magnets (48, 50, 52, 54) are so mounted that they form a square configuration.

8. Apparatus according to claims 1, 4 or 6, characterized in that said apparatus further comprises a plurality of sensor means (82, 84, 86) for sensing the position of said movable structure (64), said sensor means (82, 84, 86) providing an input to said means (80) controlling the supply of current to said coil assemblies.

**Patentansprüche**

1. Lageeinstellvorrichtung mit mehreren Magneten (12, 14, 16), die mit gegenseitigen Abständen angebracht sind, mehreren Spulenanordnungen (18, 20, 22), die so angebracht sind, daß sie sich durch die magnetischen Felder der einzelnen genannten Magneten hindurcherstrecken, einer Einrichtung (44) zum Steuern des Stromflusses durch die einzelnen genannten Spulenanordnungen, einer Einrichtung (24, 26) zum Verbinden der Spulenanordnungen, um eine bezüglich der genannten Magneten bewegbare Konstruktion zu bilden, einer Einrichtung (30) zum Halten eines Gegenstandes an der genannten Konstruktion, wobei die Spulenanordnungen so bezüglich einander angeordnet sind, daß durch Steuerung der Stromzufuhr zu den genannten Spulenanordnungen die genannte Einrichtung (30) zum Halten eines Gegenstandes wahlweise bewegt werden kann, dadurch gekennzeichnet, daß eine Einrichtung zur starren Verbindung der Spulenanordnungen (18, 20, 22) vorgesehen ist, um eine starre Konstruktion (25; 64) zu bilden, die bezüglich der genannten Magneten (12, 14, 16; 48, 50, 52, 54) beweglich ist, daß eine Lagereinrichtung (28) zum Halten der genannten starren Konstruktion (48, 50, 52, 54) beweglich ist, daß eine Lagereinrichtung (28) zum Halten der genannten starren Konstruktion auf einer Grundplatte (10) vorgesehen ist, und daß die genannten Spulenanordnungen (18, 20, 22; 56, 58, 60, 62) so mit Bezug zueinander gewickelt sind, daß durch Steuerung der Stromzufuhr zu den genannten Spulen die genannte Konstruktion (25; 64) in einer Ebene wahlweise in eine erste und/oder eine zweite Richtung (X, Y) bewegt und/oder um eine zur genannten Ebene senkrechten Achse (Z) gedreht werden kann.

2. Vorrichtung nach Anspruch 1, dadurch gekennzeichnet, daß die genannte Einrichtung zum starren Verbinden der Spulenanordnungen (18, 20, 22; 56, 60, 62) eine obere Platte (24; 66) und eine untere Platte (26; 68) umfaßt, zwischen denen die Spulenanordnungen (18, 20, 22; 56, 58, 60, 62) angeordnet sind.

3. Vorrichtung nach Anspruch 2, dadurch gekennzeichnet, daß die Magneten (12, 14, 16; 48, 50, 52, 54) an der genannten Grundplatte (10; 46) angebracht sind, und daß die Lagereinrichtung (28) die genannte untere Platte (26; 68) an der genannten Grundplatte (10; 46) abstützt.

4. Vorrichtung einem der Ansprüche 1 is 3, dadurch gekennzeichnet, daß drei Magnete (12, 14, 16) im wesentlichen in der gleichen Ebene angebracht sind, daß zwei der genannten Spulenanordnungen (18, 20) im wesentlichen parallel bezüglich zueinander gewickelt sind und die dritte Spulenanordnung (22) im wesentlichen senkrecht zu der ersten und der zweiten Spulenanordnung (18, 20) gewickelt ist.

5. Vorrichtung nach Anspruch 4, dadurch gekennzeichnet, daß die genannten Magneten (12, 14, 16) so angebracht sind, daß sie ein gleichseitiges Dreieck bilden.

6. Vorrichtung nach einem der Ansprüche 1 bis 3, dadurch gekennzeichnet, daß vier Magnete (48, 50, 52, 54) im wesentlichen in der gleichen Ebene angebracht sind, daß zwei der genannten Spulenanordnungen (56, 58) im wesentlichen parallel bezüglich zueinander gewickelt und die anderen zwei der genannten Spulenanordnungen (60, 62) im wesentlichen senkrecht zu den ersten zwei der genannten Spulenanordnungen gewickelt sind.

7. Vorrichtung nach Anspruch 6, dadurch gekennzeichnet, daß die genannten Magneten (48, 50, 52, 54) so angebracht sind, daß sie eine viereckige Anordnung bilden.

8. Vorrichtung nach den Ansprüchen 1, 4 oder 6, dadurch gekennzeichnet, daß die genannte Vorrichtung ferner eine Mehrzahl von Sensoreinrichtungen (82, 84, 86) zum Ermitteln der Position der genannten bewegbaren Konstruktion (64) umfaßt, wobei die genannten Sensoreinrichtungen (82, 84, 86) der genannten, die Stromzufuhr zu den genannten Spulenanordnungen steuernden Einrichtung (80) einen Input zuführen.

**Revendications**

1. Dispositif de positionnement comprenant plusieurs aimants (12, 14, 16) montés à différentes distances les uns des autres, plusieurs assemblages de bobines (18, 20, 22) disposés de manière à passer chacun dans les champs magnétiques de ces aimants, des moyens (44) permettant de régler le passage du courant dans ces assemblages de bobines, des moyens (24, 26) permettant de relier les assemblages de bobines pour constituer une structure susceptible de se déplacer par rapport aux aimants, des moyens (30) permettant de monter un objet sur cette structure, les assemblages de bobines étant disposés les uns par rapport aux autres de telle manière qu'en réglant le passage du courant dans les assemblages de bobines, il soit possible de déplacer sélectivement les moyens (30) permettant le montage d'un objet, caractérisé en ce qu'il comporte des moyens assurant l'assemblage rigide des assemblages de bobines (18, 20, 22) de manière à réaliser une structure rigide (25, 64) qui peut se déplacer par rapport aux aimants (12, 14, 16, 48, 50, 52, 54) et des moyens (28) de support pour le montage de cette structure rigide sur une plaque de base (10) et en ce que les assemblages de bobines (18, 20, 22, 56, 58, 60, 62) sont enroulés les uns par rapport aux autres de manière qu'en réglant le passage du courant dans les assemblages de bobines, il est possible de déplacer sélectivement la structure (25, 64) dans un plan dans une première et/ou une deuxième direction (X, Y) et/ou de la faire tourner autour d'un axe (Z) perpendiculaire audit plan.

2. Dispositif selon la revendication 1, caractérisé en ce que les moyens qui assurent la liaison rigide des assemblages de bobines (18, 20, 22, 56, 58, 60, 62) comprennent une plaque supérieure (24, 66) et une plaque inférieure (26, 68) entre lesquelles sont placées des assemblages de bobines (18, 20, 22, 56, 58, 60, 62).

3. Dispositif selon la revendication 2, caractérisé en ce que les aimants (12, 14, 16, 48, 50, 52, 54) sont montés sur la plaque de base (10, 46) et que les moyens de support (28) supportent la plaque inférieure (26, 68) sur la plaque de base (10, 46).

4. Dispositif selon l'une quelconque des revendications 1 à 3, caractérisé en ce que trois aimants (12, 14, 16) sont montés sensiblement dans un même plan, que deux assemblages de bobines (18, 20) sont enroulés essentiellement en parallèle l'un par rapport à l'autre, et que le troisième assemblage de bobines (22) est enroulé essentiellement perpendiculairement au premier et au deuxième assemblages de bobines (18, 20).

5. Dispositif selon la revendication 4, caractérisé en ce que les aimants (12, 14, 16) sont montés de manière à former un triangle équilatéral.

6. Dispositif selon l'une quelconque des revendications 1 à 3, caractérisé en ce que quatre aimants (48, 50, 52, 54) sont montés sensiblement dans un même plan, que deux des assemblages de bobines (56, 58) sont enroulés substantiellement en parallèle l'un par rapport à l'autre et que les deux autres assemblages de bobines (60, 62) sont enroulés essentiellement perpendiculairement aux deux premiers assemblages de bobines.

7. Dispositif selon la revendication 6, caractérisé en ce que les aimants (48, 50, 52, 54) sont montés de manière à former un carré.

8. Dispositif selon l'une quelconque des revendications 1, 4 ou 6, caractérisé en ce qu'il comprend également plusieurs organes de senseurs (82, 84, 86) pour la déterminer la position de la structure mobile (64), ces organes senseurs (82, 84, 86) alimentant des entrées des moyens (80) qui réglent le passage du courant dans les assemblages de bobines.

EP 0 128 433 B1

FIG. 1

FIG. 2

CONTROLLER

1

FIG.4

FIG.3